# EUROPEAN PATENT SPECIFICATION

(11) **EP 1 433 741 B1**
(45) Date of publication and mention of the grant of the patent: **18.10.2006**
(21) Application number: 03079178.4
(22) Date of filing: 23.12.2003
(51) Int. Cl.: B81B 7/00

(54) **Method for the closure of openings in a film**
Verfahren zum Verschliessen von Öffnungen in einer Schicht
Procédé pour la fermeture d'ouvertures dans une couche

(30) Priority: 24.12.2002 EP 02447270; 09.01.2003 US 439579 P
(43) Date of publication of application: 30.06.2004
(73) Proprietor: INTERUNIVERSITAIR MICROELEKTRONICA CENTRUM VZW, 3001 Leuven (BE)
(72) Inventor: Rusu, Cristina, 43169 Mölndal (SE); Witvrouw, Ann, 3020 Herent (BE)
(74) Representative: Bird, William Edward

(56) References cited:
- EP-A- 0 783 108
- WO-A-01/58804
- WO-A-99/58985
- DE-A- 10 052 419
- US-A- 5 654 232
- US-A1- 2001 002 510
- RUSU C ET AL: "PLANARIZATION OF DEEP TRENCHES" , MATERIALS RESEARCH SOCIETY SYMPOSIUM PROCEEDINGS, MATERIALS RESEARCH SOCIETY, PITTSBURG, PA, US, VOL. 4557, PAGE(S) 49-57 XP009008550 ISSN: 0272-9172 * the whole document *

## Description

### FIELD OF THE INVENTION

The present invention is related to microelectronic process technology. In particular it relates to Micro- and Nano-Electro Mechanical Systems (MEMS and NEMS) process technology. The present invention relates to a method for the closure of openings in a layer or film whereby substantially no sealing material passes through the openings as well as the resulting article. The closure of these openings can cause an underlying cavity to be hermetically sealed, in which an object can be isolated at a location. Furthermore, the invention relates to the encapsulation process of MEMS and NEMS.

### BACKGROUND OF THE INVENTION

Many micro-electromechanical systems (MEMS) require an encapsulation under vacuum or under a controlled atmosphere and pressure in order to ensure either a good performance or an acceptable lifetime of operation. The encapsulation has to be performed without the deposition of sealing material on the MEMS device, which can cause damage to the device. In "The indent reflow sealing (IRS) technique - a method for fabrication of sealed cavities for MEMS devices", *J.MEMS,* **9**, p.206-217, 2000 by H.A.T. Tilmans, M.D.J.van de Peer and E. Beyne, two approaches for wafer-scale zero-level packaging are mentioned.

The most popular approach is based on wafer bonding. Here, the sealing is performed by connecting two wafers (device wafer and capping wafer) together by means of a reflowable material. An example of such packaging is described in patent EP-A-0951069. In this approach an expensive substrate, e.g. a Si wafer or a MEMS substrate, is used as a cap to close the cavity comprising the MEMS device. These wafers are thick and the sealing ring is large. Therefore, the resulting encapsulated MEMS device is space consuming. Moreover, batch processing is not possible.

Alternatively, encapsulation can be done by the fabrication and sealing of surface micro-machined membranes. The use of conformal LPCVD (low-pressure chemical vapour deposition) films is a known method for encapsulation at low pressure [C. Liu, Y.C. Tai, "Sealing of micro machined cavities using chemical vapour deposition methods: characterisation and optimisation", *J.MEMS*, **8**, p.135-145, 1999]. The sealing of the cavity comprising the MEMS devices is done while depositing the conformal film. Hence, the atmosphere and pressure of the sealed MEMS device are those of the deposition chamber. Methods for sealing at higher pressures up to the order of atmospheric pressure and a few times that value, by the deposition of thin films, are however not widespread. Moreover, most of these atmospheric pressure techniques do not prevent material deposition inside the cavity.

MEMS devices can be very fragile and deposition of material on the device is preferably avoided. As disclosed in "Silicon processing for the VLSI era, vol. 1 - Process Technology", 2^{nd} ed., 2000, S. Wolf and R. N. Tauber, chapter 11.8, pages 475-7, hole filling may be performed by sputtering, e.g. in the formation of a via. This technique is not suitable for sealing cavities in which fragile devices are located, i.e. in cases in which the fragile device would be buried in the filling substance.

In EP0783108 A1 a method is disclosed for the closure of openings in a membrane layer of, for instance, polycrystalline silicon which is covering a cavity. Hereby a layer of doped glass is deposited on the membrane layer, such that holes of certain dimensions are not closed but slightly narrowed. A temperature step is then applied, whereby the doped glass material further enters the cavity, creeping along the lower or inner surface of the film and later along the cavity walls, such that a layer of glass is formed covering the walls of the cavity. If the openings are small enough, the underlying cavity can be sealed by this temperature step, whereby the openings are completely filled with glass material.

In US 6,337,499 B1 trenches or holes in a substrate, called cavities, are sealed by depositing a layer of doped glass on top of the substrate, hereby narrowing the opening of the cavity. A reflow step is then performed whereby the cavity is sealed by the reflowed glass layer, which partially enters the cavity. Optionally, deposition of a passivation layer, having an essentially constant thickness of for instance 50 nm, is performed. It is considered to be critical that the remaining cavity has a constant width of about 1 µm over a depth T of typical 40 µm.

### SUMMARY OF THE INVENTION

An aim of the present invention is to provide a method of sealing a opening in a film above a cavity, e.g. in a semiconductor cavity, which allows a greater freedom as to the atmosphere used during the sealing encapsulation as well as the resulting article. Preferably the sealing takes up less space. The encapsulation should preferably not involve expensive processes or materials. Preferably the process should allow hermetic sealing of an opening.

The invention provides a method for closing openings in a film, for example, in microelectronic process technology, whereby substantially no deposition material passes through the openings, which can be important if fragile micro devices are positioned under the openings. This sealing can be performed at controllable atmosphere and pressure. The closure of these openings can cause an underlying cavity to be hermetically sealed, in which an object can be isolated in a location. In particular the method provides a way for hermetically sealing cavities under controlled atmosphere and pressure in the encapsulation and sealing processes of cavities comprising fragile content. The cavities can comprise for instance Micro Electro Mechanical Systems (MEMS). The method can be used for encapsulating devices which may require a controlled atmosphere and pressure encapsulation such as micro accelerometers, micro gyroscopes, micro tubes, vibration micro sensors, micro mirrors, micro mechanical resonators or "resonant strain gauges", micro mechanical filters, micro switches, micro electrical circuits, micro relays, Integrated Circuits with air gaps etc.

The present invention provides a method for closing an opening in a film with a reflow material, the opening being an opening above an underlying cavity in a substrate, the method comprising:
- depositing an intermediate layer onto the film, said intermediate layer being stable during reflow and which narrows down the opening to be sealed due to collar or shoulder forming. The collar or shoulder forming may preferably be performed by using a deposition method with a low bottom step-coverage. This bottom step coverage should be smaller then 1. Preferably this bottom step coverage is smaller then 70, or smaller then 50%.
- depositing a reflow layer on said intermediate layer under a first set of pressure and atmosphere conditions to further partially close the opening, the deposition being such that no reflow material passes through the opening, and
- reflowing said reflow layer under a second set of pressure and atmosphere conditions to close the opening by the reflow layer covering over the opening, such that essentially no material of the reflow or sealing layer passes through the opening.

The reflowing step is preferably carried out at a temperature below 1000°C. In an embodiment of the invention, the openings are not completely filled after applying the method of the present invention.

In an embodiment of the present invention, the method may furthermore comprise depositing a wetting layer on the intermediate layer before depositing the reflow layer.

The span D of the opening may be larger then 0.5 µm but also larger then 1µm and even larger then 2.5 µm. The span of the opening may be between 0.25 µm and 5 µm. Preferably, the span of the opening is between 0.5 µm and 2.5 µm and most preferably, the span of the opening is between 1 and 1.5 µm.

The cavity may be part of a micro- or nano-electro-mechanical system (MEMS or NEMS). In one embodiment of the invention, the cavity may comprise a fragile device on which substantially no material may be deposited during the closure process to guarantee the proper working and lifetime of the device.

In one embodiment of the invention, the intermediate layer may be a dielectric layer. In a preferred embodiment, the intermediate layer may be formed by means of a chemical vapour deposition technique with low bottom step coverage.

The reflow layer may be deposited by an evaporation technique or a chemical or physical vapour deposition technique. In one embodiment, the reflow layer may be a conductive layer. The reflow layer may be planarised during or after reflow. In one embodiment the reflow layer may comprise aluminium. In a further embodiment, the reflow layer may comprise germanium.

In the method of the present invention, reflow may be performed at a temperature lower than at least one of the following:
- the melting temperature of the substrate,
- the melting temperature of the intermediate layer,
- the melting temperature of the wetting layer and
- a critical temperature of the device inside the cavity.

The cavity may be sealed under controlled atmosphere and pressure by reflowing the reflow layer under a second set of atmosphere and pressure conditions. The pressure during the reflow process may essentially be atmospheric pressure.

In one embodiment of the invention, the film may comprise more than one opening and each of said openings may belong to a different cavity. The method of the invention may allow the openings to be closed simultaneously.

The method of the present invention may be used in a batch process.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### SHORT DESCRIPTION OF FIGURES

Fig. 1 illustrates the span of an opening.
Fig. 2 illustrates the span in case of a circular and rectangular opening.
Fig. 3 shows a structure onto which the invention can be applied, namely a cavity, comprising a fragile device e.g. a MEMS device, to be sealed off by closing the openings or trenches in the film that is covering it.
Fig. 4 shows an example useful for understanding the present invention.
Fig. 5 shows a first embodiment of the present invention.
Fig. 6 shows a second embodiment of the present invention.
Fig. 7 shows experimental results related to the first embodiment of the invention: 1.5 µm evaporated Al on 2.2 µm PECVD SiO₂ on Si trenches before and after reflow.
Fig. 8 shows experimental results related to the first embodiment of the invention: 2 µm PECVD Ge, 50 W, on 2.2 µm SiO₂ on Si trenches before and after reflow.

### DETAILED DESCRIPTION

The following description and examples illustrate preferred embodiments of the present invention in detail. Those of skill in the art will recognise that there are numerous variations and modifications of this invention that are encompassed by its scope as defined by the claims. Accordingly, the description of preferred embodiments should not be deemed to limit the scope of the present invention.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the most relevant components of the device are A and B.

When in the description or in the claims the term 'a controlled atmosphere' is used, a controlled constitution of ambient gas is meant. The notion of 'horizontal' is defined as substantially orthogonal to the direction of a gravitational field, for example the earth's gravitational field..

In the present invention, a method for closing an opening in a film is disclosed wherein essentially no closing material passes through the opening. For the purpose of this invention, the notion of 'essentially no material passing through the openings' should be understood as 'no or only a limited amount of material passing in and/or through the openings'. In the context of sealing of a cavity that comprises a fragile device, it should be such that the proper working of the device is not affected by the limited amount of material that may pass.

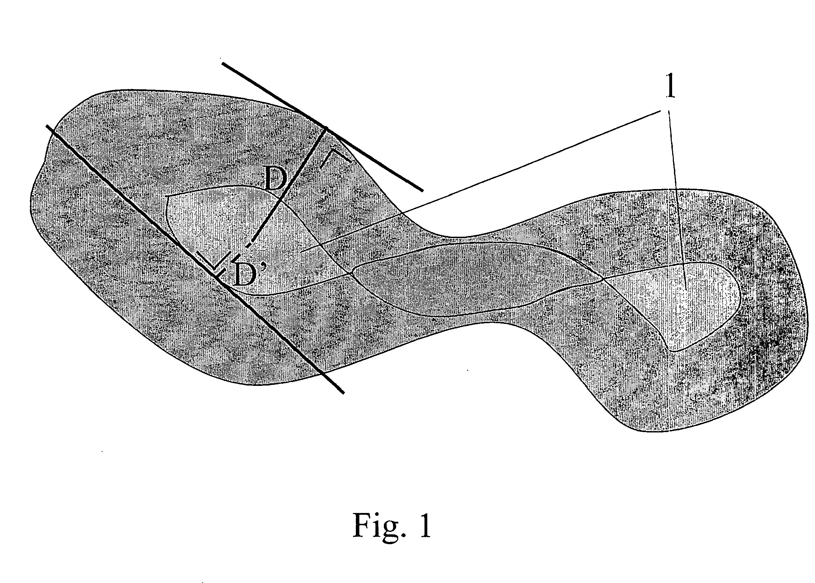

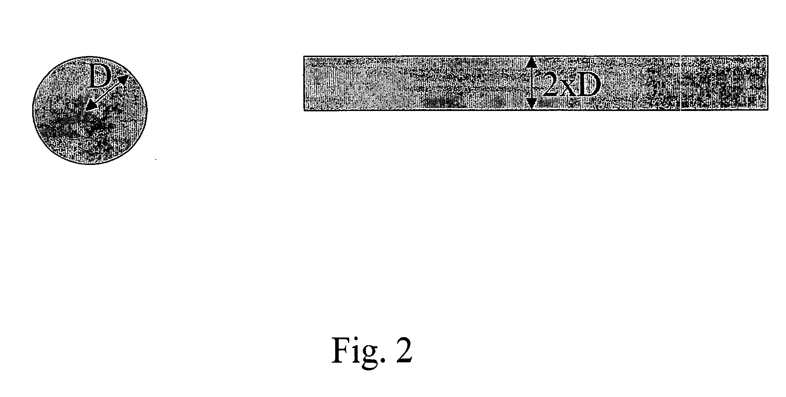

The openings in the film may be holes or trenches of different shapes. For the purpose of this invention, an indicative measure for the dimensions of the opening is given by the parameter 'span' (D) which is defined as the minimum value of the distance, measured orthogonal to the contour of the opening, for which the coverage along the whole contour of the opening causes the complete opening to be closed. This is illustrated in Fig. 1. The areas 1 are uncovered parts of the opening, after a sealing or reflow layer is deposited on top of a film that comprises openings (see further). For example, for a circular opening, D corresponds to the radius of the opening and for a rectangular opening, D corresponds to half of the width of the opening. This is illustrated in Fig. 2.

The method of the present invention may preferably be used for closure of openings with a span D between 0.25 µm and 5 µm, but larger openings are not excluded. More preferably, the method may be used for openings with a span D between 1 µm and 2.5 µm.

Preferably, the method of the present invention may be used in the field of sealing techniques for wafer-scale zero-level packaging by thin film caps, for which it brings the additional advantage of hermetically sealing at a controlled atmosphere and pressure.

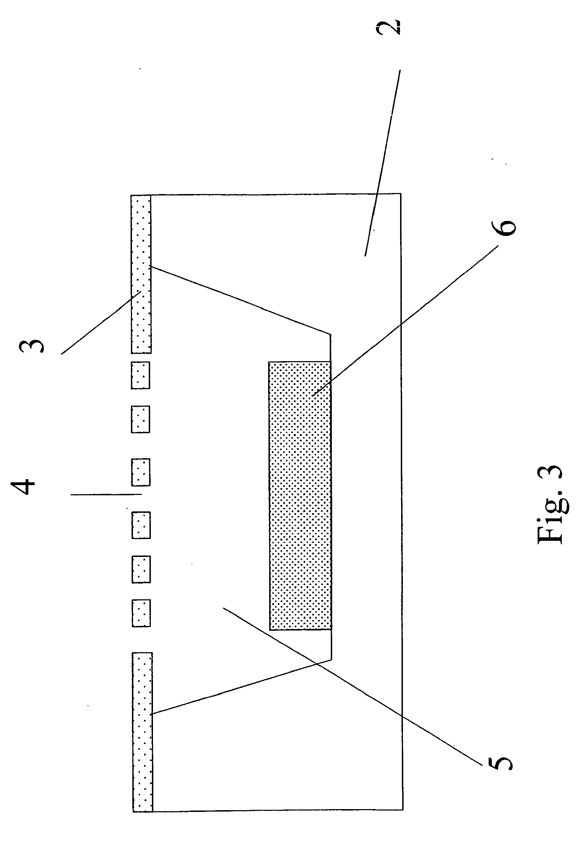

A generic illustration of a device 6, located in a cavity 5 in a substrate 2, on which the method of the present invention may be applied, is shown in Fig. 3. The substrate 2 and the film or membrane layer 3 may be any substrate 2 and film or membrane layer 3 used in MEMS processing. Examples of substrates 2, which may be used in the present invention, are for example single crystal or polycrystalline Si, single crystal or poly-crystalline Ge, glass, quartz, polymer, etc. Examples of suitable materials to form the film or membrane layer 3 are polycrystalline SiGe, metal films, oxide-based or nitride-based films, polymer, single crystal or polycrystalline Si, etc. The material of the film or membrane layer 3 may be conducting, insulating, semiconducting, etc. Furthermore, the fragile device 6, located in cavity 5, may be any MEMS device requiring a vacuum or controlled atmosphere and pressure encapsulation. Examples of such MEMS devices are micro-accelerometers, micro-gyroscopes, micro-tubes, vibration micro-sensors, micro-mirrors, micro-mechanical resonators or "resonant strain gauges", micro-mechanical filters, micro-switches, micro-electrical circuits, micro-relays, Integrated Circuits with air gaps etc.

Sealing the openings 4 in the film or membrane layer 3 may influence the atmosphere and pressure of the cavity 5.

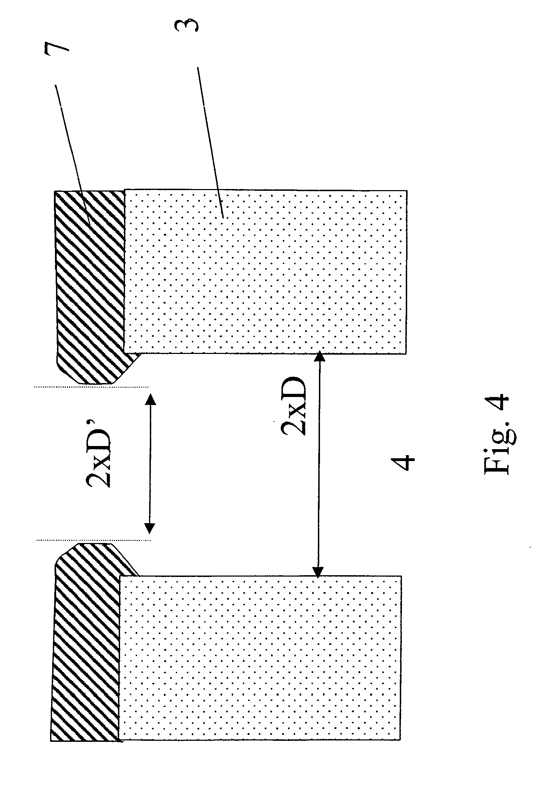

In an example useful for understanding the present invention (Fig. 4) a layer 7 of a low melting temperature material, also called sealing layer or reflow layer, is deposited on top of the film or membrane layer 3 that comprises openings 4, until the openings 4 are reduced in diameter up to being almost completely sealed. This layer 7 is preferably thin enough such that no actual closing of the cavity 5 occurs. The thickness of the sealing layer 7 may depend on the deposition parameters and the deposition technique that has been used. By depositing this sealing layer 7, the span D of the original openings 4, may be reduced to a span D', where D'<D - see Fig. 1, where this is illustrated. D may for example be between 0.25 µm and1 µm, D' may for example be between 0.03 µm and 0.05 µm or between 0.1 µm and 0.25 µm. The deposition of the sealing layer 7 may be performed under optimal conditions or parameters for deposition. This may include optimal in the sense of avoiding deposition material of the sealing layer 7 to pass through the openings. Important deposition parameters may for example be pressure, gas flow and any relevant deposition parameter. The material of the sealing layer 7 is then reflowed in a furnace with controlled atmosphere and pressure such that the openings, remaining after deposition of the sealing layer 7, are closed. This causes the underlying cavity 5 to obtain the atmosphere and pressure used for the reflow process. The reflow process does not cause essentially any amount of material to enter the openings 4. The reflow layer or sealing layer 7 can act as a functional layer of the device itself or of other devices.

This process provides a decoupling of the process of closing openings 4 in a film or membrane layer 3 and the process of sealing cavities 5 under predetermined atmosphere and pressure. For example, if a material would be deposited until the openings 4 are closed in a one step process and a controlled atmosphere and pressure would be required in the to be sealed cavity 5, the deposition conditions have to correspond with the required atmosphere and pressure in the cavity 5 after sealing. This limits the choice of deposition techniques, or limits the scope of possible atmospheres and pressures that may be required within the cavity 5. Especially, the amount of deposition material that is able to penetrate the openings 4 depends strongly upon the deposition conditions.

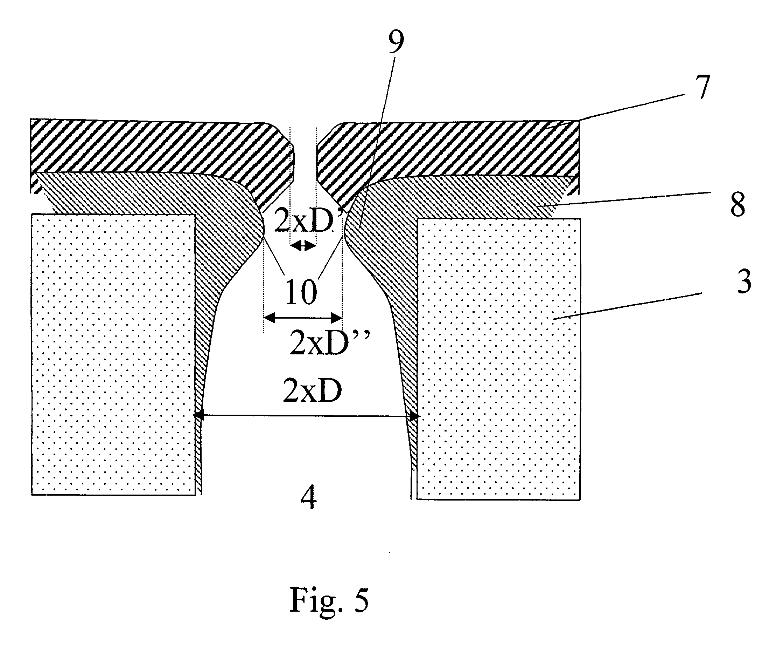

In a first embodiment of the present invention, which is illustrated in Fig.5, the method comprises the deposition of a first intermediate layer 8 in between the film or membrane layer 3 and the sealing layer 7, as shown in Fig. 5. This first intermediate layer 8 can prevent reaction between the sealing layer 7 and film or membrane layer 3, is stable during reflow and narrows down the opening 4 to be sealed, due to formation of a collar or shoulder 9, which may be the result of using a deposition method with a low bottom step coverage. The first intermediate layer 8 may preferably be a dielectric layer, e.g. a nitride layer or an oxide layer, and may, for example, be deposited by means of known chemical vapour deposition (CVD) methods with a low step-coverage, such that collars or shoulders 9 are formed. This formation of a collar is commonly known in the art of depositing materials into openings 4 but normally measures are taken to avoid the problem of formation of such collar 9 on the top of the opening 4. Here, this narrowing effect is exploited such that when the reflow or sealing layer 7 is deposited, already smaller openings 4 (D"< D) are present. The first intermediate layer 8 may insulate the later deposited sealing layer 7, which may be conductive, from the membrane layer 3. This first intermediate layer 8 may also promote the adhesion of the sealing or reflow layer 7 formed on this first intermediate layer 8.

After deposition of the first intermediate layer 8, a reflow or sealing layer 7 may then be deposited. Any material that can be deposited and which can be reflowed at a temperature below the critical temperature of the whole device may be used. Suitable deposition techniques for the sealing layer 7 on top of the first intermediate layer 8 may for example be Physical or Chemical Vapour Deposition or evaporation. The sealing layer may, in this embodiment, for example be a metal (e.g. Ti, Ta, W, Al, Cu, Cr etc.), alloys, eutectic alloys, semiconductor materials ( e.g. Ge) or solder materials (e.g. SnPb, In, Bi, etc).

Sealing may then be done by performing the final reflow step in a furnace in which the pressure and/or atmosphere may be controlled. The reflow temperature is normally a temperature somewhat below the bulk melting point of the material of the sealing layer 7, and may for example be between 30 and 100°C below this bulk melting point. Hence, materials should be selected such that the reflow temperature is preferably below the melting and evaporation temperatures of all the materials used. In other words, the reflow temperature should be below the critical temperature of the complete device and package. The reflow temperature should thus also be below the critical temperature of the substrate 2 comprising the fragile devices 6, e.g. MEMS devices, and below the critical temperature of this fragile device 6 itself. The viscosity of the material of the sealing layer 7 must be high enough such that the overlap or encroachment of the opening 4, corresponding to D", is at least maintained and that the material of the sealing layer 7 does not slide down along the sidewalls 10 of the opening 4. Preferably D'<D".

An aspect of the present invention can be planarisation during or after reflow, so that after the reflow of the sealing or reflow layer 7 a substantially flat surface may be achieved, which may be advantageous for further processing on top of the embedded device.

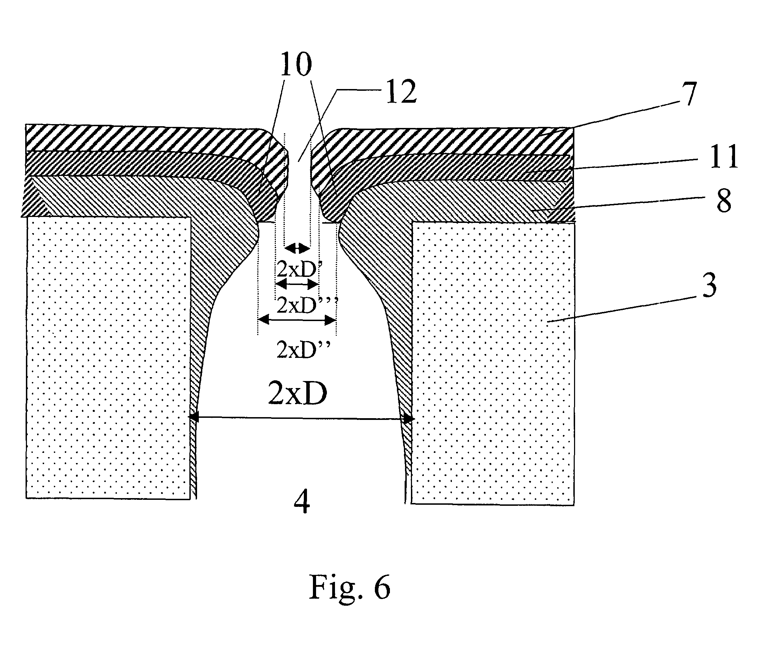

In a further embodiment of the present invention, a second intermediate layer or wetting layer 11 may be formed between the sealing or reflow layer 7 and the first intermediate layer 8, as shown in Fig 6. The material of this wetting layer 11 may be chosen such that it is a good wetting layer for the reflow of the reflow or sealing layer 7. For example, Ti may be used as a wetting layer 11 when Al is used as reflow layer 7. In this embodiment it is also the reflow or sealing layer 7 that will close the opening 4, the part corresponding to D', during the reflow process. A wetting layer 11, such as e.g. Ti or Ti-silicide, as wetting layer 11 for Al reflow, (see for example [Influence of Ti, TiN, and TiSi_{2,4} under layers on Al-Si-Cu reflow sputtering, Proceeding of *VLSI multilevel interconnection conference,* 7-8 June, Santa Clara, USA, p. 336-342, 1994.]) may lower the reflow temperature. Thus, in case no wetting layer 11 is present, if the material of the first intermediate layer 8 forms a good wetting layer for the reflow of the sealing layer 7, reflow temperatures may be lowered.

The second intermediate layer 11 may assist in closing the opening 4, because during formation of this second intermediate layer 11 the opening 4 is further narrowed (D'''<D'') (see Fig.6). The collar 10 thus formed will again prevent sliding down of the material of the reflow or sealing layer 7 along the sides of the opening 4, but will result in the piling up of the reflow material within the spacing, corresponding to D"', of the remaining openings 12 located between the parts of the wetting layer 11.

The 'reflow' at higher pressure, as e.g. atmospheric pressure depends on the 'native oxide' film that is on e.g. the sealing layer 7, which may in this embodiment be a metal. A 'protection layer', e.g. Au, can prevent the formation of the 'native oxide'.

The atmosphere and the pressure inside the furnace can be used to determine the final pressure and atmosphere inside the cavity 5. Possible atmospheres are, for example, inert gasses such as He or Ar, nitrogen or other gasses such as oxygen. The pressure may preferably be any pressure between vacuum pressure (e.g. 10E-6 mbar) and a few times atmospheric pressure. More preferably, the pressure may be a pressure between vacuum pressure and 2 atm. Even more preferably, the pressure may be a pressure between vacuum pressure and 1.2 atm.

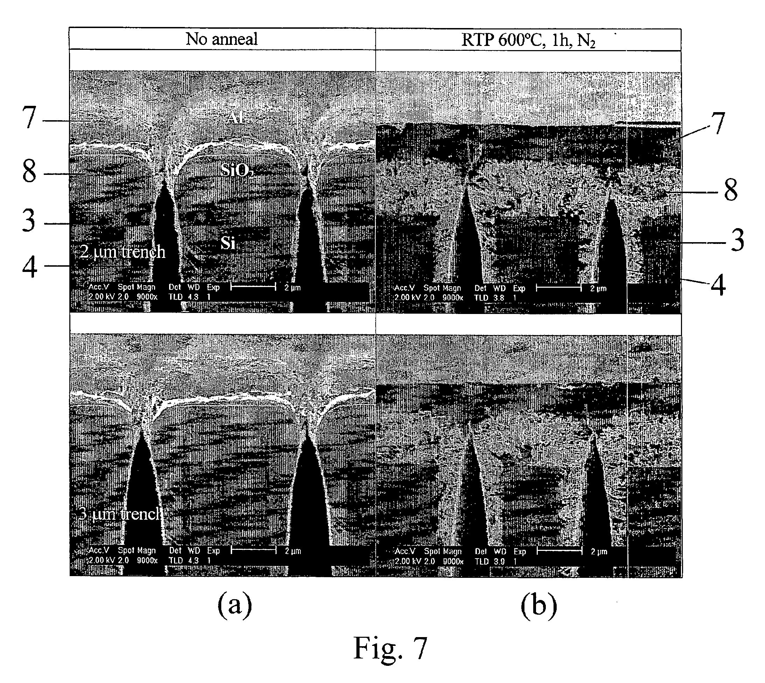

A specific example of closing the opening is depicted in Fig. 7. Fig. 7(a) shows the device without annealing, while in Fig. 7(b) the device is shown after reflow at 600°C. In this example, the reflow or sealing material is a metal, i.e. Al, which may, besides sealing the openings or trenches 4, be used as an electrical contact layer. An intermediate layer 8 of PECVD SiO₂ is deposited between the membrane layer 3, which is in this example Si, and the sealing layer 7, in this example thus Al. Reflow is performed at 600°C for 1 hour in a N₂ atmosphere at atmospheric pressure, closing the trenches 4 as can be seen in Fig. 7(b). Substantially no material entered the trenches 4. This means that essentially no material would enter a cavity 5 located below said trenches 4. From Fig. 7, the collar shape of the PECVD SiO₂ may be clearly seen.

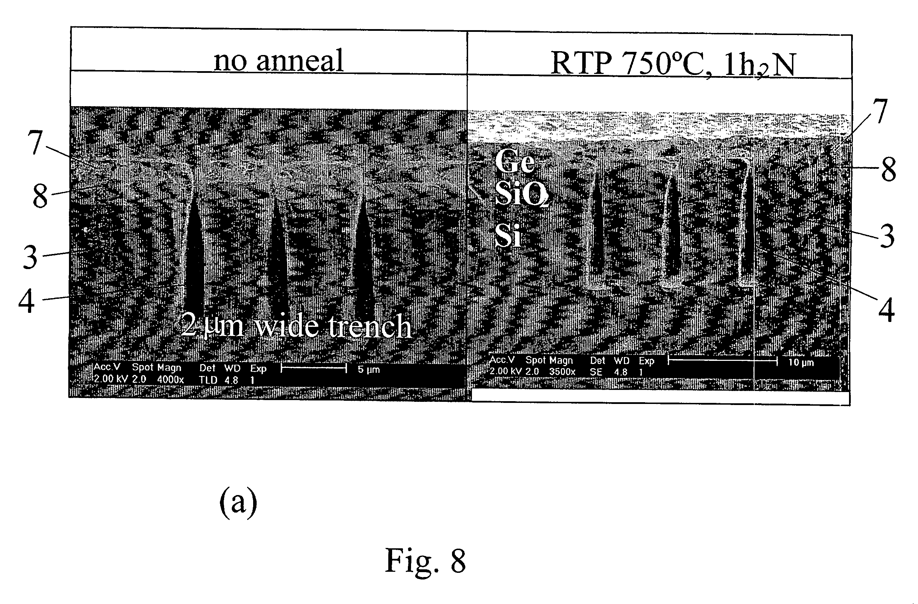

Another specific example of closing the opening is shown in Fig.8. Here, PECVD Ge is deposited as a sealing layer 7 on top of an intermediate layer 8 of SiO₂. The Ge deposition is performed at a RF power of 50 W and reflow is performed at 750°C for 1 hour in a N₂ atmosphere at atmospheric pressure. Different Ge thickness and annealing conditions may be applied. In Fig. 8 it is shown that 2 µm wide trenches 4 (about 10 µm deep) are closed by Ge. After reflow the surface of the device is flat.

In a specific example, trenches 4 of 2 µm width and 12 µm depth are produced in a substrate 2. On top of this substrate 2 a 2.5 µm thick layer of SiO₂ is deposited by PECVD. This results in a bottom step coverage of about 13%.

Experiments have shown that the narrowing towards almost-closure of openings 4 of a certain width 2D (within the dimensions claimed in this specification), may be achieved by the deposition of an intermediate layer 8 with a thickness slightly thicker then the width 2D; for example a thickness of about 125 % x 2D. The wider the openings 4 to be closed, the thicker the thickness of the intermediate layer 8 needs to be to achieve the narrowing towards almost-closure of the openings 4. In general, the thickness of the intermediate layer 8 required for narrowing towards almost-closure of openings 4 is dependent on the deposition process and parameters used.

## Claims

1. A method for closing an opening (4) in a film (3) with a reflow material, said opening (4) being an opening (4) above an underlying cavity (5) in a substrate (2), the method comprising:
a) depositing an intermediate layer (8) which is thermally stable during reflow said film (3) comprising said opening (4) above said cavity (5), on said film (3), to thereby narrow down the opening (4) to be sealed by formation of a collar or shoulder (9),
b) depositing a reflow layer (7) comprising reflow material on said intermediate layer (8) under a first set of pressure and atmosphere conditions to further partially close the opening (4), the deposition being such that no reflow material passes through said opening (4), and
c) reflowing said reflow layer (7) under a second set of pressure and atmosphere conditions to close the opening (4) by the reflow layer (7) covering over the opening (4), such that essentially no material of the reflow layer (7) passes through the opening (4).

2. The method according to claim 1, wherein the depositing of the intermediate layer is performed by a deposition method with a low bottom step-coverage.

3. The method according to claim 1 or 2, wherein said openings (4) are not completely closed after step (c).

4. The method according to any of claims 1 to 3, further comprising depositing a wetting layer (11) on said intermediate layer (8) before depositing said reflow layer (7).

5. The method according to any of claims 1 to 4, wherein said opening (4) has a span within the range of 0.25 µm and 5 µm, or within the range of 0.5 µm and 2.5 µm, or within the range of 1 µm and 1.5 µm.

6. The method according to any of claims 1 to 5, wherein said intermediate layer (8) is a dielectric layer.

7. The method according to any of claims 1 to 6, wherein said intermediate layer (8) is formed by a chemical vapour deposition technique with low bottom step coverage.

8. The method according to any of claims 1 to 7, wherein said reflow layer (7) is a layer deposited by an evaporation technique or a chemical or physical vapour deposition technique.

9. The method according to any of claims 1 to 8, wherein said reflow layer (7) is a conductive layer.

10. The method according to any of claims 1 to 9, wherein said reflow layer (7) is planarised during or after reflow.

11. The method according to any of the claims 1 to 10, wherein the cavity (5) is part of a Micro- or Nano-Electro-Mechanical System (6).

12. The method according to any of the claims 1 to 11, wherein reflow is performed at a temperature lower than at least one of the following: the melting temperature of the substrate (2), the melting temperature of said film (3), the melting temperature of said intermediate layer (8), the melting temperature of said wetting layer (9), and a critical temperature of the device (6) inside the cavity (5).

13. The method according to any of claims 1 to 12, wherein the cavity (5) is sealed under controlled atmosphere and pressure by reflowing said reflow layer (7) under said second set of atmosphere and pressure conditions.

14. The method according to any of claims 1 to 13, wherein the pressure during the reflow process is essentially atmospheric pressure.

15. The method according to any of claims 1 to 14, wherein the cavity (5) comprises a fragile device (6) on which substantially no material may be deposited during the closure process to guarantee the proper working and lifetime of the device (6).

16. The method according to any of claims 1 to 15, wherein said film (3) comprises more than one opening (4) and each of said openings (4) is located above a different cavity (5) in a substrate, and wherein said openings (4) are closed simultaneously.

17. The method according to any of claims 1 to 16, used in a batch process.

18. The method according to any of the claims 1 to 17, wherein said reflow layer (7) comprises aluminium.

19. The method according to any of the claims 1 to 18, wherein said reflow layer (7) comprises germanium.

## Patentansprüche

1. Verfahren zum Verschließen einer Öffnung (4) in einem Film (3) mit einem Aufschmelzmaterial, wobei die Öffnung (4) eine Öffnung (4) oberhalb eines darunter liegenden Hohlraums (5) in einem Substrat (2) ist, wobei das Verfahren die Schritte aufweist:
a) Abscheiden einer Zwischenschicht (8), die während eines Aufschmelzens thermisch stabil ist, auf dem Film (3), wobei der Film (3) die Öffnung (4) oberhalb des Hohlraums (5) beinhaltet, zum Verengen durch eine Bildung eines Kragens oder einer Schulter (9) zu versiegelnde Öffnung verengt,
b) Abscheiden einer Aufschmelzschicht (7), die ein Aufschmelzmaterial auf der Zwischenschicht (8) aufweist, bei einem ersten Satz von Druck- und Atmosphärenbedingungen, um ferner teilweise die Öffnung (4) zu verschließen, wobei die Abscheidung derart ist, dass kein Aufschmelzmaterial durch die Öffnung (4) passiert, und
c) Aufschmelzen der Aufschmelzschicht (7) bei einem zweiten Satz von Druck- und Atmosphärenbedingungen, um die Öffnung (4) durch die Aufschmelzschicht (7), die die Öffnung (4) bedeckt, zu verschließen, so dass im Wesentlichen kein Material der Aufschmelzschicht (7) durch die Öffnung (4) passiert.

2. Verfahren nach Anspruch 1, wobei die Abscheidung der Zwischenschicht durch ein Abscheidungsverfahren mit einer geringen unteren Stufenbedeckung durchgeführt wird.

3. Verfahren nach einem der Ansprüche 1 oder 2, wobei die Öffnungen (4) nicht vollständig nach dem Schritt (c) geschlossen sind.

4. Verfahren nach einem der Ansprüche 1 bis 3, die ferner aufweist: Abscheiden einer Benetzungsschicht (11) auf der Zwischenschicht (8), bevor die Aufschmelzschicht (7) abgeschieden wird.

5. Verfahren nach einem der Ansprüche 1 bis 4, wobei die Öffnung (4) eine Spanne im Bereich von 0,25 µm bis 5 µm oder innerhalb des Bereichs von 0,5 µm bis 2,5 µm oder innerhalb des Bereichs von 1 µm bis 1,5 µm aufweist.

6. Verfahren nach einem der Ansprüche 1 bis 5, wobei die Zwischenschicht (8) eine dielektrische Schicht ist.

7. Verfahren nach einem der Ansprüche 1 bis 6, wobei die Zwischenschicht (8) durch eine chemische Gasphasenabscheidungstechnik mit einer geringen unteren Stufenbedeckung gebildet wird.

8. Verfahren nach einem der Ansprüche 1 bis 7, wobei die Aufschmelzschicht (7) eine Schicht ist, die durch eine Verdampfungstechnik oder eine chemische oder eine physikalische Gasphasenabscheidungstechnik abgeschieden wird.

9. Verfahren nach einem der Ansprüche 1 bis 8, wobei die Aufschmelzschicht (7) eine leitfähige Schicht ist.

10. Verfahren nach einem der Ansprüche 1 bis 9, wobei die Aufschmelzschicht (7) nach oder während eines Aufschmelzens planarisiert wird.

11. Verfahren nach einem der Ansprüche 1 bis 10, wobei der Hohlraum (5) Teil eines mikro- oder nanoelektromechanischen Systems (6) ist.

12. Verfahren nach einem der Ansprüche 1 bis 11, wobei ein Aufschmelzen bei einer Temperatur geringer als mindestens einer der folgenden durchgeführt wird: der Aufschmelztemperatur des Substrats (2), der Aufschmelztemperatur des Films (3), der Schmelztemperatur der Zwischenschicht (8), der Schmelztemperatur der Benetzungsschicht (9) und einer kritischen Temperatur der Vorrichtung (6) innerhalb des Hohlraums (5).

13. Verfahren nach einem der Ansprüche 1 bis 12, wobei der Hohlraum (5) bei gesteuerter Atmosphäre und Druck durch Aufschmelzen der Aufschmelzschicht (7) bei dem zweiten Satz von Atmosphären- und Druckbedingungen versiegelt wird.

14. Verfahren nach einem der Ansprüche 1 bis 13, wobei der Druck während des Aufschmelzverfahrens im Wesentlichen ein atmosphärischer Druck ist.

15. Verfahren nach einem der Ansprüche 1 bis 14, wobei der Hohlraum (5) eine empfindliche Vorrichtung (6) aufweist, auf welcher im Wesentlichen kein Material während des Verschließungsverfahrens abgeschieden werden kann, um den ordnungsgemäßen Betrieb und die Lebensdauer der Vorrichtung (6) zu garantieren.

16. Verfahren nach einem der Ansprüche 1 bis 15, wobei der Film (3) mehr als eine Öffnung (4) aufweist und jede der Öffnungen (4) oberhalb eines unterschiedlichen Hohlraums (5) in einem Substrat angeordnet ist und wobei die Öffnungen (4) simultan geschlossen werden.

17. Verfahren nach einem der Ansprüche 1 bis 16, die in einem Stapelverfahren verwendet werden.

18. Verfahren nach einem der Ansprüche 1 bis 17, wobei die Aufschmelzschicht (7) Aluminium aufweist.

19. Verfahren nach einem der Ansprüche 1 bis 18, wobei die Aufschmelzschicht (7) Germanium aufweist.

## Revendications

1. Procédé d'obturation d'une ouverture (4) présente dans une couche (3), par un matériau de refusion, ladite ouverture (4) étant une ouverture (4) située au-dessus d'une cavité (5) sous-jacente située dans un substrat (2), le procédé comprenant :
a) le dépôt d'une couche intermédiaire (8), qui est thermiquement stable pendant la refusion sur ladite couche (3), ladite couche (3) comportant ladite ouverture (4) au-dessus de ladite cavité (5), pour ainsi rétrécir, par la formation d'une collerette ou d'un épaulement (9), l'ouverture (4) à fermer hermétiquement ;
b) le dépôt d'une couche de refusion (7) comprenant un matériau de refusion, sur ladite couche intermédiaire (8) en utilisant un premier ensemble de paramètres de pression et d'atmosphère afin de refermer partiellement davantage l'ouverture (4), le dépôt étant tel que du matériau de refusion ne puisse pas passer à travers ladite ouverture (4) ; et
c) la refusion de ladite couche de refusion (7) en utilisant un second ensemble de paramètres de pression et d'atmosphère, pour obturer l'ouverture (4) par la couche de refusion (7) recouvrant l'ouverture (4), de telle sorte qu'essentiellement aucun matériau de la couche de refusion (7) ne passe à travers l'ouverture (4).

2. Procédé selon la revendication 1, dans lequel le dépôt de la couche intermédiaire est effectué par un procédé de dépôt ayant un faible recouvrement de gradin de fond.

3. Procédé selon la revendication 1 ou 2, dans lequel lesdites ouvertures (4) ne sont pas complètement obturées après l'étape (c).

4. Procédé selon l'une quelconque des revendications 1 à 3, comprenant en outre le dépôt d'une couche de mouillage (11) sur ladite couche intermédiaire (8) avant le dépôt de ladite couche de refusion (7).

5. Procédé selon l'une quelconque des revendications 1 à 4, dans lequel ladite ouverture (4) a une étendue comprise dans la plage de 0,25 µm à 5 µm, ou dans la plage de 0,5 µm à 2,5 µm, ou dans la plage de 1 µm à 1,5 µm.

6. Procédé selon l'une quelconque des revendications 1 à 5, dans lequel ladite couche intermédiaire (8) est une couche diélectrique.

7. Procédé selon l'une quelconque des revendications 1 à 6, dans lequel ladite couche intermédiaire (8) est formée par un procédé de dépôt chimique en phase vapeur à faible recouvrement de gradin de fond.

8. Procédé selon l'une quelconque des revendications 1 à 7, dans lequel ladite couche de refusion (7) est une couche déposée par un procédé d'évaporation ou par un procédé de dépôt chimique ou physique en phase vapeur.

9. Procédé selon l'une quelconque des revendications 1 à 8, dans lequel ladite couche de refusion (7) est une couche conductrice.

10. Procédé selon l'une quelconque des revendications 1 à 9, dans lequel ladite couche de refusion (7) est planarisée pendant ou après la refusion.

11. Procédé selon l'une quelconque des revendications 1 à 10, dans lequel ladite cavité (5) fait partie d'un système micro- ou nano-électromécanique (6).

12. Procédé selon l'une quelconque des revendications 1 à 11, dans lequel la refusion est exécutée à une température inférieure à au moins l'une des températures suivantes : la température de fusion du substrat (2), la température de fusion de ladite couche (3), la température de fusion de ladite couche intermédiaire (8), la température de fusion de ladite couche de mouillage (9), et une température critique du dispositif (6) placé dans ladite cavité (5).

13. Procédé selon l'une quelconque des revendications 1 à 12, dans lequel la cavité (5) est scellée sous atmosphère et sous pression contrôlées, par la refusion de ladite couche de refusion (7) en utilisant ledit second ensemble de paramètres d'atmosphère et de pression.

14. Procédé selon l'une quelconque des revendications 1 à 13, dans lequel la pression, pendant le processus de refusion, est essentiellement la pression atmosphérique.

15. Procédé selon l'une quelconque des revendications 1 à 14, dans lequel la cavité (5) comprend un dispositif (6) fragile sur lequel sensiblement aucun matériau ne peut être déposé pendant le processus d'obturation, afin de garantir le fonctionnement approprié et la durée de vie du dispositif (6).

16. Procédé selon l'une quelconque des revendications 1 à 15, dans lequel ladite couche (3) comprend plus d'une ouverture (4), et chacune desdites ouvertures (4) est située au-dessus d'une cavité (5) différente dans un substrat, et dans lequel lesdites ouvertures (4) sont obturées simultanément.

17. Procédé selon l'une quelconque des revendications 1 à 16, utilisé dans une production par lots.

18. Procédé selon l'une quelconque des revendications 1 à 17, dans lequel ladite couche de refusion (7) comprend de l'aluminium.

19. Procédé selon l'une quelconque des revendications 1 à 18, dans lequel ladite couche de refusion (7) comprend du germanium.
